# EUROPÄISCHE PATENTSCHRIFT

(11) **EP 2 015 033 B1**
(45) Veröffentlichungstag und Bekanntmachung des Hinweises auf die Patenterteilung: **22.03.2017**
(21) Anmeldenummer: 07011630.6
(22) Anmeldetag: 13.06.2007
(51) Int. Cl.: G01D 11/24, H05K 9/00, H05K 1/02, H05K 1/14

(54) **Sensor**
Sensor
Capteur

(43) Veröffentlichungstag der Anmeldung: 14.01.2009
(73) Patentinhaber: Pepperl & Fuchs GmbH, 68307 Mannheim (DE)
(72) Erfinder: Fornefeld, Axel, 92245 Kümmersbruck (DE); Luber, Ernst, 92259 Neukirchen (DE); Pohl, Norbert, 92278 Illschwang (DE); Pürzer, Josef, 92421 Schwandorf (DE)
(74) Vertreter: Schiffer, Axel Martin

(56) Entgegenhaltungen:
- EP-A- 0 653 612
- US-A- 4 792 879
- US-A- 5 031 027

## Beschreibung

Die Erfindung betrifft einen Sensor mit einem von einer Abschirmung umgebenen Sensorelement.

Derartige Sensoren sind aus der Praxis bekannt. Um einen kompakten Schaltungsaufbau bei miniaturisierten, z.B. kubischen Sensoren zu schaffen, werden bisher flexible oder starr flexible Leiterplatten oder mehrere verschachtelte Einzelleiterplatten eingesetzt. Die Einzelleiterplatten werden über Steckkontakte oder durch Handlötungen miteinander verbunden. Zum Schutz gegen elektrische Störstrahlung wird das umschließende Gehäuse metallisiert oder eine Abschirmfolie um den Schalteinsatz mit der Schaltung gefaltet. Über eine Kontaktierfläche an der Abschirmung oder mit einer Litze wird die Abschirmung an ein Massepad des Schalteinsatzes des Sensors angelötet.

US 4,792,879 beschreibt einen elektrischen Schalter, bei dem zur elektrischen Abschirmung von elektronischen Komponenten eine gewickelte Leitungsschicht in einem Schaltergehäuse vorgesehen ist.

Zudem ist aus der US 5,031,027 ein Schaltkreis bekannt, der von einer an flexiblen Bereichen gefalteten Trägersubstratschicht umgeben ist, um den Schaltkreis elektrisch abzuschirmen.

Der Erfindung liegt die Aufgabe zugrunde, einen miniaturisierten Sensor der oben genannten Art zu schaffen, der bei geringem konstruktivem Aufwand eine hohe Störfestigkeit aufweist.

Die Aufgabe wird dadurch gelöst, dass der Sensor einen durch mindestens drei Leiterplatten gebildeten Leiterplattenstapel mit einem Innenraum aufweist, und dass im Innenraum an zumindest einer Innenseite einer der Leiterplatten störempfindliche Schaltungsteile liegen, die durch den Leiterplattenstapel gegenüber Störstrahlung von außen geschützt sind.

Vorteilhafte Weiterbildungen der Erfindung sind den Unteransprüchen zu entnehmen.

Ein Ausführungsbeispiel der Erfindung wird im Folgenden anhand einer Zeichnung näher erläutert. Es zeigen:
- FIG 1: eine Explosionsdarstellung des erfindungsgemäßen Sensors mit einem Schalteinsatz und Gehäusekomponenten,
- FIG 2: eine Querschnittsdarstellung des erfindungsgemäßen Sensors und
- FIG 3, 4: einen Leiterplattenstapel des Sensors.

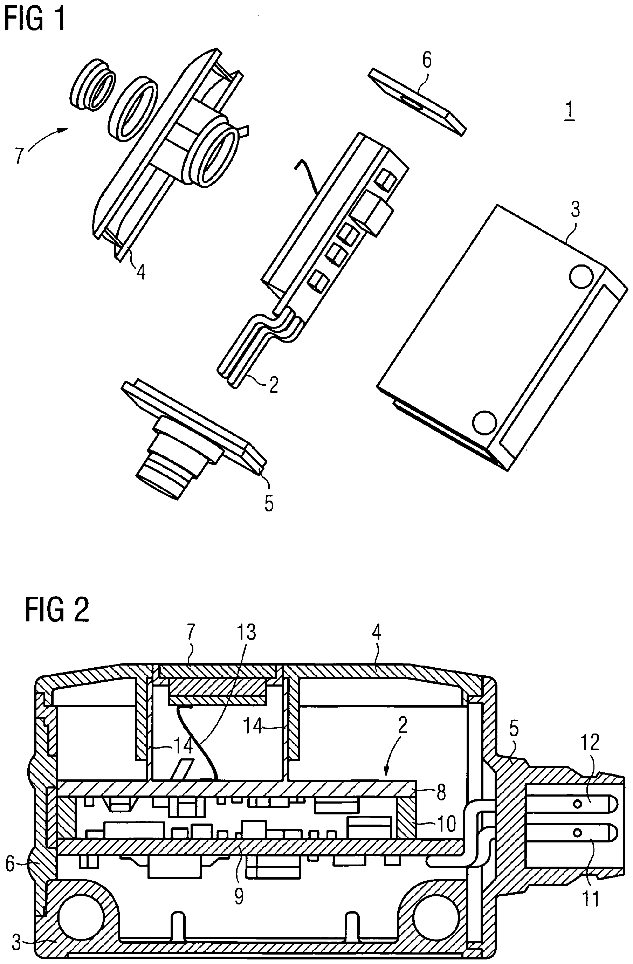

FIG 1 gibt eine Explosionsdarstellung des erfindungsgemäßen Sensors 1 wider. Als wesentliche Komponenten sind hier ein Schalteinsatz 2, ein Gehäuseunterteil 3, ein Gehäusedeckel 4, zwei Seitenabdeckungen 5, 6 und ein Sensorelement 7 gezeigt.

In FIG 2 ist der zusammenmontierte Sensor 1 im Querschnitt dargestellt. Der Schalteinsatz 2 weist zwei parallel angeordnete Leiterplatten 8, 9 auf, die über eine als Rahmen dienende weitere Leiterplatte 10 elektrisch verbunden sind. Die auf den Leiterplatten 8, 9 angeordnete Schaltung umfasst störempfindliche Schaltungsteile, wie z.B. Verstärker oder Mikrocontroller, die in dem durch die Leiterplatten 8, 9, 10 gebildeten Innenraum an den Innenseiten der Leiterplatten 8, 9 liegen und weniger störempfindliche Schaltungsteile, die hier an der Außenseite der als Auswerteleiterplatte ausgeführten Leiterplatte 9 angeordnet sind. Die Schaltung ist zum Anschluss an eine Stromversorgung mit zwei Steckerstiften 11, 12 elektrisch verbunden. Im Gehäusedeckel 4 ist eine Öffnung, in die das Sensorelement 7, hier ein Ultraschallwandler eingepasst ist, der über eine Signalleitung 13 mit der Schaltung auf der Sensorleiterplatte 8 elektrisch verbunden ist. Eine als Abschirmhülse ausgeführte Abschirmung 14 ist im Gehäusedeckel 4 integriert und umgibt sowohl den Ultraschallwandler 7 als auch die Signalleitung 13. Die Abschirmhülse 14 ist mit der als Sensorleiterplatte ausgeführten Leiterplatte 8 verlötet und gewährleistet dadurch in diesem Bereich eine komplette Schirmung.

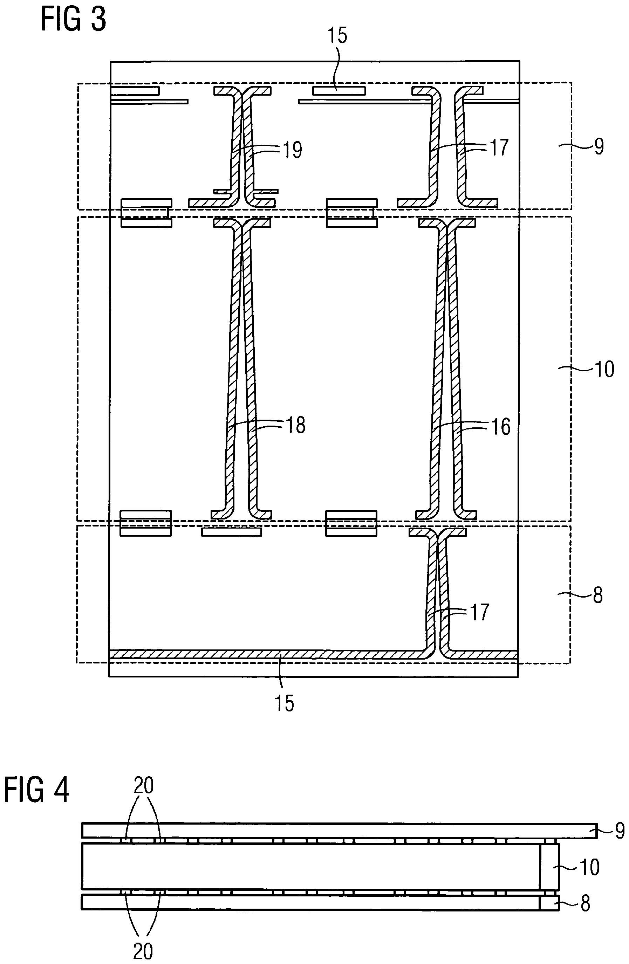

Die störempfindlichen Schaltungsteile an den Innenseiten der Leiterplatten 8, 9 sind nach außen durch Masselayer in diesen Leiterplatten 8, 9 gemäß FIG 3 gegenüber elektrischer Störstrahlung von außen geschützt. Die als Rahmen dienende weitere Leiterplatte 10 weist Masseleitungen 16 auf, die die Masselayer 15 über zusätzliche Masseanbindungen 17 in den beiden Leiterplatten 8 und 9 verbinden. Parallel zu den Masseleitungen 16 und Masseanbindungen 17 verlaufen Signalleitungen 18 und Signalanbindungen 19, der Verbindungsstellen 20 angedeutet sind. Die oben genannten Masse- 16 und Signalleitungen 18 sind als Durchkontaktierungen, d.h. hülsenförmig ausgeführt, wobei in der FIG 3 der Querschnitt sichtbar ist.

Alle Verbindungen sind sternförmig, möglichst symmetrisch aufgebaut, wodurch eine hohe Störfestigkeit gegenüber leitungsgeführten Störungen erreicht wird. Durch eine Metallisierung der Außenseiten der als Rahmen ausgebildeten Leiterplatte 10 kann die Schirmung der Innenlagen des Leiterplattenstapels noch verbessert werden. Die Metallisierung, z.B. in Form von Kupferflächen ist mit Masse verbunden.

Mit dem beschriebenen Aufbau lässt sich ein miniaturisierter Sensor, z.B. in kubischer Bauform realisieren, der hohen Anforderungen gegenüber Störstrahlung genügt.

## Patentansprüche

1. Sensor (1) mit einem von einer Abschirmung (14) umgebenen Sensorelement (7),
**dadurch gekennzeichnet,**
**dass** der Sensor (1) einen durch mindestens drei Leiterplatten (8, 9, 10) gebildeten Leiterplattenstapel mit einem Innenraum aufweist,
**dass** zwei der Leiterplatten (8, 9) Masselayer (15) aufweisen und mit ihren Flächen parallel zueinander beabstandet sind, dass die als Rahmen dienende dritte Leiterplatte (10) die zwei Leiterplatten (8, 9) miteinander verbindet,
**dass** eine dem Innenraum abgewandte Außenseite der dritten Leiterplatte (10) eine mit Masse verbundene Metallisierung aufweist und
**dass** im Innenraum an zumindest einer Innenseite einer der Leiterplatten (8, 9, 10) störempfindliche Schaltungsteile liegen, die durch den Leiterplattenstapel gegenüber Störstrahlung von außen geschützt sind.

2. Sensor mit Anspruch 1,
**dadurch gekennzeichnet,**
**dass** die Abschirmung (14) mit dem Leiterplattenstapel verbunden ist und eine das Sensorelement (7) mit dem Leiterplattenstapel verbindende Signalleitung (13) innerhalb der Abschirmung (14) verläuft.

3. Sensor nach einem der vorangehenden Ansprüche,
**dadurch gekennzeichnet,**
**dass** die Abschirmung als Abschirmhülse (14) ausgeführt ist.

4. Sensor nach einem der vorangehenden Ansprüche,
**dadurch gekennzeichnet,**
**dass** das Sensorelement als Ultraschallwandler (7) ausgeführt ist.

5. Sensor nach einem der vorangehenden Ansprüche,
**dadurch gekennzeichnet,**
**dass** der Sensor (1) eine kubische Bauform aufweist.

## Claims

1. Sensor (1) having a sensor element (7) surrounded by a shielding (14),
**characterised in that**
the sensor (1) has a printed circuit board (PCB) stack, formed by at least three PCBs (8, 9, 10), with an inner space,
that two of the PCBs (8, 9) have ground layers (15) and are spaced apart with their surface areas parallel to each other,
that the third PCB (10) serving as a frame connects the two PCBs (8, 9) to each other,
that an outer side, facing away from the inner space, of the third PCB (10) has a metal plating connected to ground, and
that interference-susceptible circuitry components lie in the inner space on at least one inner side of one of the PCBs (8, 9, 10), these circuitry components being protected by the PCB stack against interference radiation from externally.

2. Sensor with claim 1,
**characterised in that**
the shielding (14) is connected to the PCB stack and a signal line (13) connecting the sensor element (7) to the PCB stack runs inside the shielding (14).

3. Sensor according to one of the preceding claims,
**characterised in that**
the shielding is designed as a shielding sleeve (14).

4. Sensor according to one of the preceding claims,
**characterised in that**
the sensor element is configured as an ultrasonic transducer (7).

5. Sensor according to one of the preceding claims,
**characterised in that**
the sensor (1) has a cuboidal structural form.

## Revendications

1. Capteur (1) avec un élément de capteur (7) entouré d'un blindage (14),
**caractérisé en ce**
**que** le capteur (1) présente une pile de cartes à circuits imprimés avec un espace intérieur formée par au moins trois cartes à circuits imprimés (8, 9, 10),
**que** deux des cartes à circuits imprimés (8, 9) présentent des couches de masse (15) et sont espacées l'une de l'autre avec leur surfaces parallèles entre elles, que la troisième carte à circuits imprimés (10) faisant office de châssis relie entre elles les deux cartes à circuits imprimés (8, 9),
**qu'**un côté extérieur de la troisième carte à circuits imprimés (10), opposé à l'espace intérieur, présente une métallisation reliée à la masse, et
**que** se trouvent, dans l'espace intérieur, au niveau au moins d'un côté intérieur d'une des cartes à circuits imprimés (8, 9, 10), des pièces de commutation sensibles aux interférences, lesquelles sont protégées, par la pile de cartes à circuits imprimés, du rayonnement parasite provenant de l'extérieur.

2. Capteur selon la revendication 1,
**caractérisé en ce**
**que** le blindage (14) est relié à la pile de cartes à circuits imprimés, et une ligne de signalisation (13) reliant l'élément de capteur (7) à la pile de cartes à circuits imprimés s'étend à l'intérieur du blindage (14).

3. Capteur selon l'une quelconque des revendications précédentes,
**caractérisé en ce**
**que** le blindage est réalisé sous la forme d'une douille de blindage (14).

4. Capteur selon l'une quelconque des revendications précédentes,
**caractérisé en ce**
**que** l'élément de capteur est réalisé sous la forme d'un transducteur à ultrasons (7).

5. Capteur selon l'une quelconque des revendications précédentes,
**caractérisé en ce**
**que** le capteur (1) présente une structure en forme de cube.
